Europäisches Patentamt

(19) European Patent Office

Office européen des brevets

(11) **EP 1 193 745 A1**

(12) **EUROPEAN PATENT APPLICATION**
published in accordance with Art. 158(3) EPC

(43) Date of publication:
**03.04.2002 Bulletin 2002/14**

(51) Int Cl.[7]: **H01L 21/304**, C09K 3/14

(21) Application number: **01902753.1**

(22) Date of filing: **02.02.2001**

(86) International application number:
**PCT/JP01/00774**

(87) International publication number:
**WO 01/57919 (09.08.2001 Gazette 2001/32)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **04.02.2000 JP 2000067743**

(71) Applicant: **SHOWA DENKO K.K.**
**Tokyo 105-8518 (JP)**

(72) Inventors:
• **Shimazu, Yoshitomo**
 **Shiojiri-shi, Nagano 399-6461 (JP)**
• **Kido, Takanori**
 **Shiojiri-shi, Nagano 399-6461 (JP)**
• **Uotani, Nobuo C/O SHOWA DENKO K. K.**
 **Chiba-shi, Chiba 267-0056 (JP)**

(74) Representative: **Strehl Schübel-Hopf & Partner**
 **Maximilianstrasse 54**
 **80538 München (DE)**

(54) **POLISHING COMPOSITE FOR USE IN LSI MANUFACTURE AND METHOD OF MANUFACTURING LSI**

(57)     A polishing composition for an LSI device, comprising water, abrasive particles, an organic acid and an oxidizing agent and having the pH adjusted to 5.5-9.0 with an alkali substance, for the purpose of increasing the polishing rate for Ta and TaN during polishing of a Ta or TaN barrier metal (4) and a copper wiring layer (6), to prevent dishing and erosion. A manufacturing process for an LSI device using the polishing composition for polishing of a copper-based metal wiring layer (6) having copper (5a, 5b, 6) deposited on an insulating film (2) by way of a barrier metal (4) composed of Ta or TaN.

Fig.3

Fig.4

**Description**

<u>Technical Field</u>

The present invention relates to a composition for polishing metal layers and barrier films in a LSI device manufacturing process, to a polishing composition which is particularly suited for polishing multiple metal layers and thin-films wherein the metal layers are of copper and the thin-films are of a tantalum-containing alloy comprising tantalum or tantalum nitride, and to a process, for manufacturing LSI devices, which employs the polishing composition.

<u>Background Art</u>

Polishing working has become one of the foundational techniques supporting the ever increasing higher integration of LSI devices. Manufacturing steps for LSI devices incorporate polishing working techniques such as embedded metal polishing (damascene method) for formation of microwiring required for micronization of design rules. However, the higher integration of LSIs has led to such problems as increased roughness of semiconductor surfaces, wiring breakage and greater resistance values due to the level differences produced by the roughness, and reduced reliability caused by occurrence of electromigration and the like. This has heightened the need for flattening techniques to eliminate the roughness between layers, one such technique being CMP (chemical mechanical polishing).

Copper is a low resistance wiring material with satisfactory electromigration resistance and excellent performance characteristics. Currently, as no effective plasma etching or publicly known technique for wet etching of copper exists that can form suitable mutual connections between copper in a mechanical manner, CMP of copper has been proposed as a realistic method for forming suitable mutual connections between copper on LSIs. For this purpose there have been proposed CMP compositions that can be suitably used to form mutual connections between copper on LSIs.

When copper is employed as a wiring material, a copper film is formed after forming some sort of barrier metal to prevent diffusion of the copper, because of the large diffusion coefficient of copper into interlayer insulation films. Common barrier metals include the highly effective materials Ta and TaN which have high barrier properties. However, the difficulty of polishing removal of Ta and TaN has constituted a problem for CMP. When the polishing rate ratio between the barrier metal and copper is small, the phenomena of dishing and erosion generally occur before complete removal of the barrier metal.

Whether the copper and barrier metal are simultaneously removed by polishing in a single CMP step or whether the copper and barrier metal are separately removed by polishing in two CMP steps, the ratio between the polishing rate of the barrier metal composed of Ta or TaN and the polishing rate of the copper at the stage of polishing removal of the barrier metal is preferably at least 1.0, in order to inhibit dishing and the like.

However, such performance has been unobtainable with conventional polishing compositions, and this has been an impediment to their practical use. For example, the CMP slurry "EP-C4110" by Cabot, mentioned on page 84 of the Preprint for a conference entitled "Thorough Verification of Metal CMP" held by the Electronic Journal (2/27/1998), has a polishing rate ratio of 1/12 for Ta and copper.

The following two publications also describe prior art for the present invention, although they do not mention the polishing rate of the barrier metals.

The first is Japanese Unexamined Patent Publication HEI No. 10-46140 by the present inventors, and it discloses a neutral composition for polishing of LSI devices, comprising a carboxylic acid, an oxidizing agent and water.

The other is Japanese Unexamined Patent Publication HEI No. 8-45934, which discloses a composition for polishing of LSI devices which comprises abrasive particles treated with a surface-treatment agent containing amino groups.

As mentioned above, Japanese Unexamined Patent Publication HEI No. 10-46140, by the present inventors, discloses a neutral composition, for polishing LSI devices, comprising a carboxylic acid, an oxidizing agent and water. However, the use of abrasive particles treated with a coupling agent is not mentioned, nor is there any mention of the barrier metal polishing performance. It also does not teach that the copper polishing rate is lowered by adjusting the pH with at least one type of alkali substance selected from among alkali metal hydroxides such as NaOH, KOH, etc., alkali metal carbonates such as $Na_2CO_3$, $K_2CO_3$, etc., alkaline earth metal hydroxides such as $Mg(OH)_2$, $Ca(OH)_2$, etc. and hindered amines such as 2,2,6,6-tetramethyl-4-hydroxypiperidine, 2,2,6,6-tetramethylpiperidine, 2,2,6,6-tetramethyl-4-piperidone, 2,2,4,4,6-pentamethyl-2,3,4,5-tetrahydropyrimidine, 1,9-diaza-2,2,8,8,10,10-hexamethyl-spiro[5.5]undecan-4-one and 6-aza-7,7-dimethylspiro[4.5]decan-9-one. Consequently, it is not easy to arrive at the present invention based on this publication alone, and the patentability of the present invention is in no way lessened thereby.

On the other hand, Japanese Unexamined Patent Publication HEI No. 8-45934 discloses polishing of metal wiring layer surfaces of semiconductor boards using abrasive particles treated with a surface-treatment agent containing amino groups.

As clearly stated in the published specification (page 2, right column, lines 16-42), this technique serves to improve the dispersion property of silicon oxide fine particles in acidic solution, and to inhibit scratches on the surfaces of the multilayer wiring layers and interlayer insulation films of LSI devices. As the means therefor, there have been proposed silicon oxide fine particles with a basic layer formed on the surface by surface treatment with an organic silicon compound containing amino groups. Examples thereof describe a process of polishing a tungsten wiring layer using silicon oxide fine particles surface treated with γ-aminopropyltriethoxysilane or N-2-aminoethyl-3-aminopropyltrimethoxysilane by solution reaction.

This technique does not lessen the patentability of the present invention, for the following reasons.

(1) The technique described in the published specification improves the dispersion property of the silicon oxide fine particles in acidic solution, and as mentioned in Example 1, for example,

$$K_2[Fe(CN)_6] + KH_2PO_4$$

is added to the slurry for an acidity of pH 5.0.

On the other hand, the pH of the composition of the present invention is in the neutral to weakly alkali range of 5.5-10.0, and there is no effect of improved dispersion property of the silicon oxide fine particles by surface treatment.

Furthermore, since the composition of the present invention allows control of the polishing rate ratio of the barrier metal and copper by adjustment from neutral to weakly alkali and can reduce the copper dissolution rate, no aspect thereof is taught in the aforementioned publication, which assumes use in the acidic range.

(2) The aforementioned published specification nowhere mentions the polishing rate for the wiring layer metal or barrier metal. While the Examples describe a process of polishing a tungsten wiring layer, the evaluation is only concerned with scratches.

On the other hand, the technical object of the present invention is control of the ratio of the polishing rate for the barrier metal comprising Ta or TaN and the polishing rate for copper to within a specified range in order to prevent problems such as dishing, and therefore no aspect thereof is taught in the aforementioned publication.

(3) Although the published specification mentions the type of surface treatment agent and surface treatment method, it does not specify the amount of the surface treatment agent.

The amount of treatment agent which gives an effect according to the present invention is 0.001-50 mass% with respect to the abrasive particles, and this is not taught in the aforementioned publication.

It is an object of the present invention to provide a polishing composition for copper LSI device polishing having a high polishing rate for Ta or TaN, both of which are effective as barrier metal materials in copper wiring LSI devices, and producing little dishing or erosion, as well as a manufacturing process for LSI devices which employs the polishing composition.

Disclosure of the Invention

As a result of diligent efforts toward solving the problems described above, the present inventors have found that a polishing composition comprising water, abrasive particles, an organic acid and an oxidizing agent and having the pH adjusted to 5.5-10.0 with an alkali substance exhibits excellent performance for LSI device polishing.

According to the invention, it is necessary to first increase the polishing rate for barrier metals comprising Ta or TaN. Adding an organic acid and oxidizing agent and adjusting the pH to 5.5-10.0 can give the desired polishing rate.

On the other hand, in order to minimize the polishing rate for copper, it is preferred to adjust the pH using at least one type of alkali substance selected from among alkali metal hydroxides such as NaOH, KOH, etc., alkali metal carbonates such as $Na_2CO_3$, $K_2CO_3$, etc., alkaline earth metal hydroxides such as $Mg(OH)_2$, $Ca(OH)_2$, etc. and hindered amines such as 2,2,6,6-tetramethyl-4-hydroxypiperidine, 2,2,6,6-tetramethylpiperidine, 2,2,6,6-tetramethyl-4-piperidone, 2,2,4,4,6-pentamethyl-2,3,4,5-tetrahydropyrimidine, 1,9-diaza-2,2,8,8,10,10-hexamethyl-spiro[5.5]undecan-4-one and 6-aza-7,7-dimethylspiro[4.5]decan-9-one.

Since the composition of the invention has a pH of 5.5-10.0 (neutral to weakly alkali), the erosion is very low and dissolution of copper is not a problem. The solubility of copper can be evaluated by an immersion test at room temperature, and the dissolution rate (etch rate) is calculated by a gravimetric method. A polishing composition according to the invention has a copper dissolution rate of no greater than 5 nm/min, preferably no greater than 3 nm/min and more preferably no greater than 1 nm/min, meaning that copper is substantially insoluble therein.

Preferred modes of the invention will now be described.

(1) A polishing composition for an LSI device which is used to form a metal wiring layer, characterized by being a polishing composition comprising water, abrasive particles, an organic acid and an oxidizing agent and having the pH adjusted to 5.5-10.0 with an alkali substance.

(2) A polishing composition for an LSI device which is used to form a metal wiring layer, comprising water, abrasive particles, an organic acid and an oxidizing agent and having the pH adjusted to 5.5-9.0 with an alkali substance.

(3) The above-mentioned polishing composition for an LSI device wherein the metal wiring layer is a copper-based metal wiring layer having copper deposited on an insulating film with a barrier metal composed of Ta or TaN therebetween.

(4) The above-mentioned polishing composition for an LSI device wherein the ratio of the polishing rate for the barrier metal composed of Ta or TaN and the polishing rate for copper is 1.0 or greater.

(5) The above-mentioned polishing composition for an LSI device wherein the copper dissolution rate is no greater than 5 nm/min.

(6) The above-mentioned polishing composition for an LSI device wherein the copper dissolution rate is no greater than 1 nm/min.

(7) The above-mentioned polishing composition for an LSI device wherein the alkali substance is KOH.

(8) The above-mentioned polishing composition for an LSI device wherein the alkali substance is at least one type of hindered amine selected from among 2,2,6,6-tetramethyl-4-hydroxypiperidine, 2,2,6,6-tetramethylpiperidine, 2,2,6,6-tetramethyl-4-piperidone, 2,2,4,4,6-pentamethyl-2,3,4,5-tetrahydropyrimidine, 1,9-diaza-2,2,8,8,10,10-hexamethyl-spiro[5.5]undecan-4-one, 6-aza-7,7-dimethylspiro[4.5]decan-9-one and 1-aza-2,2-dimethylspiro[5.5]undecan-4-one.

(9) The above-mentioned polishing composition for an LSI device wherein the abrasive particles are composed mainly of at least one type of compound selected from among silicon oxide, aluminum oxide, cerium oxide, titanium oxide, zirconium oxide, complex metal oxides and metal hydroxides.

(10) The above-mentioned polishing composition for an LSI device wherein the abrasive particles are of a metal oxide produced by a vapor phase method.

(11) The above-mentioned polishing composition for an LSI device wherein the abrasive particles are of silicon oxide produced by a vapor phase method.

(12) The above-mentioned polishing composition for an LSI device wherein the abrasive particles are of a metal oxide produced by a vapor phase method using a chloride as the starting material, and the residual chlorine content is no greater than 0.3 mass%.

(13) The above-mentioned polishing composition for an LSI device wherein in the secondary particle size distribution of the abrasive particles, the maximum value is 5 $\mu$m and the average value is 0.01-1.0 $\mu$m.

(14) The above-mentioned polishing composition for an LSI device wherein the specific surface area of the abrasive particles is 5-400 $m^2$/g.

(15) The above-mentioned polishing composition for an LSI device wherein the abrasive particles have been surface treated with a coupling agent.

(16) The above-mentioned polishing composition for an LSI device wherein the coupling agent is at least one type of coupling agent selected from among silane coupling agents, titanate coupling agents, zirconate coupling agents, aluminum coupling agents and phosphate coupling agents.

(17) The above-mentioned polishing composition for an LSI device wherein the coupling agent has one or more amino groups.

(18) The above-mentioned polishing composition for an LSI device wherein the coupling agent is at least one type of amino group-containing coupling agent selected from among 3-(aminoethylaminopropyl)methyldimethoxysilane, 3-(aminoethylaminopropyl)trimethoxysilane, 3-(aminoethylaminopropyl)triethoxysilane, 3-aminopropyltrimethoxysilane and 3-aminopropyltriethoxysilane.

(19) The above-mentioned polishing composition for an LSI device wherein the amount of the coupling agent used for treatment is 0.001-50 mass% with respect to the abrasive particles.

(20) The above-mentioned polishing composition for an LSI device wherein the concentration of abrasive particles that have been surface treated with the coupling agent is 0.1-20 mass%.

(21) The above-mentioned polishing composition for an LSI device wherein the organic acid is a carboxylic acid.

(22) The above-mentioned polishing composition for an LSI device wherein the organic acid is at least one organic acid selected from among malic acid, nicotinic acid, gluconic acid, citric acid, tartaric acid, succinic acid, acetic acid, oxalic acid, adipic acid, butyric acid, capric acid, caproic acid, caprylic acid, glutaric acid, glycolic acid, formic acid, fumaric acid, maleic acid, malonic acid, phthalic acid, propionic acid and pyruvic acid.

(23) The above-mentioned polishing composition for an LSI device wherein the concentration of the organic acid is 0.01-20 mass%.

(24) The above-mentioned polishing composition for an LSI device wherein the oxidizing agent is hydrogen peroxide.

(25) The above-mentioned polishing composition for an LSI device wherein the concentration of the oxidizing agent is 0.1-20 mass%.

(26) A manufacturing process for an LSI device whereby a structure is provided comprising a copper-based metal wiring layer having copper deposited on an insulating film with a barrier metal composed of Ta or TaN therebetween and the structure is polished with a polishing composition, the process being characterized in that the polishing composition comprises water, abrasive particles, an organic acid and an oxidizing agent and has its pH adjusted to 5.5-9.0 with an alkali substance.

(27) A manufacturing process for an LSI device, characterized by forming a barrier metal layer composed of Ta or TaN on the entire surface of an insulating film including depressions formed therein, depositing copper on the barrier metal layer so that copper is completely embedded in the depressions, and then polishing the copper on the barrier metal layer and the barrier metal using the aforementioned polishing composition while selectively leaving the copper embedded in the depressions of the insulating film to form an embedded copper wiring layer.

Brief Description of the Drawings

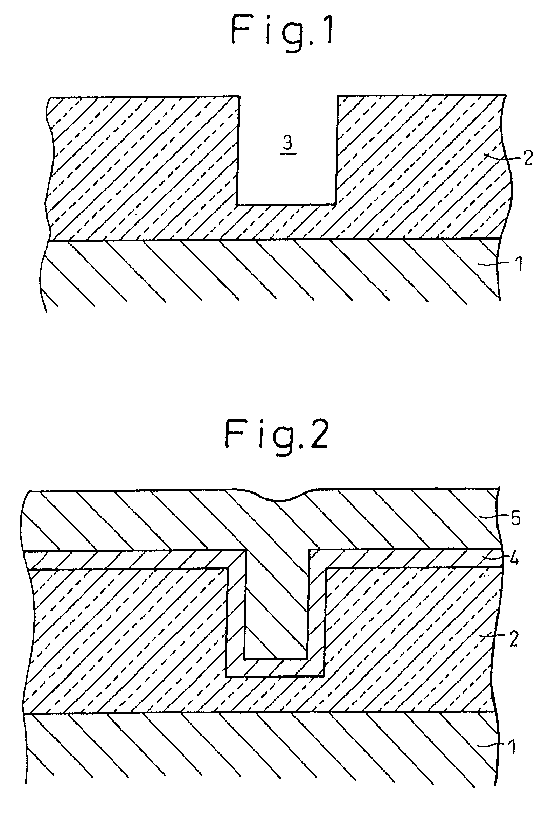

Figs. 1 to 4 are process drawings illustrating a process of forming a copper wiring layer according to the invention.

Preferred Modes of the Invention

The present invention is a composition, for polishing an LSI device, which is used to form a metal wiring layer and which comprises water, abrasive particles, an oxidizing agent and an organic acid and has the pH adjusted to 5.5-10.0, and preferably 5.5-9.0, with an alkali substance; it is suitable for use in cases where the metal wiring layer is a copper-based metal wiring layer having copper deposited on an insulating film with a barrier metal composed of Ta or TaN therebetween. The ratio of the polishing rate for the barrier metal composed of Ta or TaN and the polishing rate for copper is also preferably 1.0 or greater, to prevent dishing and erosion. This ratio of the polishing rates is more preferably in the range of 1.0-2.0.

According to the invention, the pH of the polishing composition is adjusted to 5.5-10.0, more preferably 5.5-9.0, even more preferably 6.0-9.0 and most preferably 7.0-9.0. If the pH is below 5.5 there is a risk of an increased copper dissolution rate, while if it is higher than 10.0 the danger during polishing operation increases due to a greater load on the waste water treatment.

In order to minimize the copper polishing rate, the pH adjustment is preferably accomplished using at least one type of alkali substance selected from among alkali metal hydroxides such as NaOH, KOH, etc., alkali metal carbonates such as $Na_2CO_3$, $K_2CO_3$, etc., alkaline earth metal hydroxides such as $Mg(OH)_2$, $Ca(OH)_2$, etc. and hindered amines such as 2,2,6,6-tetramethyl-4-hydroxypiperidine, 2,2,6,6-tetramethylpiperidine, 2,2,6,6-tetramethyl-4-piperidone, 2,2,4,4,6-pentamethyl-2,3,4,5-tetrahydropyrimidine, 1,9-diaza-2,2,8,8,10,10-hexamethyl-spiro[5.5]undecan-4-one and 6-aza-7,7-dimethylspiro[4.5]decan-9-one. KOH is preferred for its proven efficacy in polishing LSI devices. Hindered amines may also be suitably used because they contain no metal components that may adversely affect the device characteristics.

There are no particular restrictions on the method of pH adjustment, and the alkali substance itself may be added to the composition, or all or part of the alkali substance to be added may be added as a salt of an organic acid. The added alkali substance may also be present as a salt which has reacted with the organic acid.

The abrasive particles used for the invention will now be explained.

According to the invention, there are no particular restrictions on the type of abrasive particles, but it is preferably at least one type of compound selected from among silicon oxide, aluminum oxide, cerium oxide, titanium oxide, zirconium oxide, complex metal oxides and metal hydroxides.

Of these, metal oxide particles produced by a gas phase method are most preferred because they minimize scratches and make it easier to increase the polishing rate for the barrier metal. A vapor phase method usually produces metal oxide particles by hydrolysis reaction using a chloride or the like as the starting material, but when a large excess of unreacted chlorine remains, the slurry viscosity tends to be undesirably increased and unwanted erosion of copper may also occur. The residual chlorine content is preferably no greater than 0.3 mass%.

Silicon oxide particles are even more preferred because they are easy to surface treat with the coupling agent, among the metal oxide particles produced by the vapor phase method.

The secondary particle size distribution of the abrasive particles may be measured by dynamic light scattering, and the maximum value ($d_{max}$) is preferably no greater than 5 μm, more preferably no greater than 3 μm and most preferably no greater than 1 μm. If it exceeds 5 μm, it is not preferred because minute scratches may be created on the polished surface.

In the secondary particle size distribution of the abrasive particles, the average value ($d_{50}$) is preferably

0.01-1.0 μm, and more preferably 0.1-0.5 μm. If it is less than 0.01 μm it becomes difficult to achieve a high polishing rate for the barrier metal, while if it exceeds 1 μm, minute scratches may be created on the polished surface.

The specific surface area of the abrasive particles is preferably 5-400 $m^2/g$, more preferably 20-350 $m^2/g$ and most preferably 50-300 $m^2/g$. The specific surface area referred to here is the value measured by the nitrogen absorption method, known as the BET method. The specific surface area is preferably not less than 5 $m^2/g$ because minute scratches may be created on the polished surface. Also, if the specific surface area exceeds 400 $m^2/g$, it becomes difficult to achieve a high polishing rate for the barrier metal, and a low residual chlorine content cannot be easily achieved.

The coupling agent preferred for use with the abrasive particles of the invention will now be explained.

According to the invention, it is necessary to increase the polishing rate for barrier metals composed of Ta or TaN, and the abrasive particles are preferably surface treated with a coupling agent to increase the barrier metal polishing rate.

The surface treatment with a coupling agent increases the affinity of the abrasive particles for resin pads, so that the abrasive particles are satisfactorily held on the pad. As a result, the proportion of abrasive particles contributing to polishing becomes greater, and the polishing rate for the barrier metal is improved. Treatment with a coupling agent containing amino groups can positively charge the abrasive particle surfaces. For polishing of Ta or TaN, the polishing proceeds with the abrasive particles in contact with $Ta_2O_5$ produced on the surfaces, but since $Ta_2O_5$ is negatively charged, it has high affinity for the positively charged abrasive particles. That is, treatment with a coupling agent containing amino groups can increase the affinity between the abrasive particles and the barrier metal, resulting in an improved polishing rate for the barrier metal.

The coupling agent used for the invention may be a silane coupling agent, titanate coupling agent, zirconate coupling agent, aluminum coupling agent, phosphate coupling agent or the like. As examples of silane coupling agents there may be mentioned vinyltrichlorosilane, 1,2-dichloroethyltrichlorosilane, 1-chloroethyltrichlorosilane, 2-chloroethyltrichlorosilane, ethyltrichlorosilane, 3,3,3-trifluoropropyltrichlorosilane, 2-cyanoethyltrichlorosilane, allyltrichlorosilane, 3-bromopropyltrichlorosilane, 3-chloropropyltrichlorosilane, n-propyltrichlorosilane, 3-cyanopropyltrichlorosilane, n-butyltrichlorosilane, isobutyltrichlorosilane, pentyltrichlorosilane, hexyltrichlorosilane, benzyltrichlorosilane, p-tolyltrichlorosilane, 6-trichlorosilyl-2-norbornane, 2-trichlorosilylnorbornane, heptyltrichlorosilane, 2-(4-cyclohexenylethyl)trichlorosilane, octyltrichlorosilane, chlorophenylethyltrichlorosilane, tetradecyltrichlorosilane, octadecyltrichlorosilane, eicosyltrichlorosilane, docosyltrichlorosilane, chloromethyltrimethoxysilane, methyltrimethoxysilane, mercaptomethyltrimethoxysilane, vinyltrimethoxysilane, ethyltrimethoxysilane, 3,3,3-trifluoropropyltrimethoxysilane, 2-cyanoethyltrimethoxysilane, 3-chloropropyltrimethoxysilane, 3-mercaptopropyltrimethoxysilane, 3-aminopropyltrimethoxysilane, 2-aminoethylaminomethyltrimethoxysilane, butyltrimethoxysilane, 3-trifluoroacetoxypropyltrimethoxysilane, 3-(aminoethylaminopropyl)trimethoxysilane, phenyltrimethoxysilane, 3-glycidoxypropyltrimethoxysilane, 3-allylaminopropyltrimethoxysilane, hexyltrimethoxysilane, 3-morpholinopropyltrimethoxysilane, 3-piperazinopropyltrimethoxysilane, 3-[2-(2-aminoethylaminoethylamino)propyl]trimethoxysilane, 2-(3,4-epoxycyclohexyl)ethyltrimethoxysilane, 3-piperidinopropyltrimethoxysilane, 3-phenylaminopropyltrimethoxysilane, 3-cyclohexylaminopropyltrimethoxysilane, 0,0'-diethyl-S-(2-triethoxysilylethyl) dithiophosphate, 3-benzylaminopropyltrimethoxysilane, 3-methacryloxypropyltrimethoxysilane, methyltriethoxysilane, vinyltriethoxysilane, ethyltriethoxysilane, 3-chloropropyltriethoxysilane, propyltriethoxysilane, 3-aminopropyltriethoxysilane, 2-(2-aminoethylthioethyl)triethoxysilane, pentyltriethoxysilane, 4-chlorophenyltriethoxysilane, phenyltriethoxysilane, benzyltriethoxysilane, 6-triethoxysilyl-2-norbornane, octyltriethoxysilane, 3-(triethoxysilylpropyl)-p-nitrobenzamide, dodecyltriethoxysilane, octadecyltriethoxysilane, allyltriethoxysilane, 3-glycidoxypropyltriethoxysilane, 3-methacryloxypropyltriethoxysilane, 3-(aminoethylaminopropyl)triethoxysilane, methyltripropoxysilane, vinyltris(2-methoxyethoxy)silane, 3-glycidoxypropylmethyldiethoxysilane, 3-methacryloxypropylmethyldimethoxysilane, 3-methacryloxypropylmethyldiethoxysilane and 3-(aminoethylaminopropyl)methyldimethoxysilane. Also, although silicones with hydrolyzable groups in their structure, including silazanes and their derivatives such as condensates, chlorosilanes and their derivatives such as condensates and alkoxysilanes and their derivatives such as condensates, are usually not classified as silane coupling agents, they may also be used for the invention. As examples of titanate coupling agents there may be mentioned neopentyl(diallyl)oxytri(dioctyl) pyrophosphate titanate and the like. As examples of zirconate coupling agents there may be mentioned cyclo(dioctyl) pyrophosphate dioctyl zirconate and the like. As examples of aluminum coupling agents there may be mentioned acetoalkoxyaluminium diisopropylate and the like. As examples of phosphate coupling agents there may be mentioned dibutyl-2-methacryloyloxydiethyl phosphate and the like. Of these, silane coupling agents are used most frequently in the industry, and offers advantages in terms of cost, abundance of types and ready availability. Among these silane coupling agents there are preferred alkoxy-based silanes, examples of which include vinyltrimethoxysilane, vinyltriethoxysilane, 2-(3,4-epoxycyclohexyl)ethyltrimethoxysilane, 3-glycidoxypropyltrimethoxysilane, 3-glycidoxypropyltriethoxysilane, 3-glycidoxypropylmethyldiethoxysilane, 3-methacryloxypropyltrimethoxysilane, 3-methacryloxypropyltriethoxysilane, 3-methacryloxypropylmethyldimethoxysilane, 3-methacryloxypropylmethyldiethoxysilane, 3-aminopropyltrimethoxysilane, 2-aminoethylaminomethyltrimethoxysilane, 3-(aminoethylaminopropyl)trimethoxysilane, 3-[2-(2-aminoethylaminoethylamino)propyl]trimethoxysilane, 3-phenylaminopropyltrimethoxysilane, 3-cyclohexylaminopropyltrimethoxysilane, 3-benzylaminopropyltrimethoxysilane, 3-aminopropyltriethoxysilane, 2-(2-aminoethylthioethyl)triethoxysilane, 3-(aminoethylaminopropyl)triethoxysilane, 3-(aminoethylaminopropyl)methyldimethoxysilane, 3-chloropropyltrimethoxysilane, 3-chloropropyltriethoxysilane, mercaptomethyltrimethoxysilane and 3-mercaptopropyltrimethoxysilane. Also, amino group-containing silane coupling agents such as 3-(aminoethylaminopropyl)methyldimethoxysilane, 3-(aminoethylaminopropyl)trimethoxysilane, 3-(aminoethylaminopropyl)triethoxysilane, 3-aminopropyltrimethoxysilane and 3-aminopropyltriethoxysilane are most advantageous for use in a polishing composition of the invention employing water as the dispersion medium because of their high stability in aqueous solution.

The appropriate amount, of these coupling agents, to be used will depend on the type of coupling agent, the surface treatment method and the properties of the abrasive particles to be surface treated, but it is preferably 0.001-50 mass%, more preferably 0.01-30 mass% and even more preferably 0.1-20 mass% with respect to the abrasive particles. It is preferably not less than 0.001 mass% because it is difficult to achieve the effect of improved affinity between the abrasive particles and the pad. If it exceeds 50 mass%, however, the abrasive particles become water-repellent and may not be easily suspended in water, while the coupling agent prevents direct contact between the abrasive particles and the barrier metal to be worked, thus tending to reduce the polishing rate.

The surface treatment method with the coupling agent according to the invention is not particularly restricted. Common methods established in the industry may be employed, including a dry method in which the abrasive particles are forcibly agitated with a V-blender or the like while spraying the coupling agent solution with dry air or nitrogen for adequate mixing, and then heat treatment is carried out, at about 100-200°C, for condensation reaction on the abrasive particle surfaces, and a wet method in which the abrasive particles are dispersed in water to make a slurry, the coupling solution is added for solid solution separation, and then drying is effected at about 100-200°C. According to the invention, heat treatment at approximately 100-200°C, which is a commonly conducted surface treatment for coupling agents, may be omitted. That is, the effect of surface treatment with the coupling agent is still obtained even by simply mixing a prescribed amount of the coupling agent in the slurry of the abrasive particles suspended in water.

As mentioned above, the polishing composition containing abrasive particles surface treated with a coupling agent according to the invention is obtained by dispersing the abrasive particles surface treated with the coupling agent in water, and preferably purified water. Since a consistent effect of surface treatment of the abrasive particles with the coupling agent is achieved even when a prescribed amount of the coupling agent is mixed with a polishing composition composed of a slurry of the abrasive particles suspended in water, this may be used as the polishing composition of the invention. There are no particular restrictions on the dispersion method of the inorganic compound, and any known dispersing machine such as a stirrer, a homomixer, a turbine mixer, a medium stirring mill or the like may be used. Here, a known dispersing agent suitable for aqueous slurries, such as a polycarboxylic acid salt, naphthalenesulfonate formalin condensate or the like may also be added. Also, precipitation sorting, filtration or the like may be employed to eliminate the rough aggregated particles.

According to the invention, the abrasive particle concentration is preferably 0.1-20 mass%, more preferably 0.5-15 mass% and even more preferably 1.0-10 mass%. If the abrasive particle concentration is less than 0.1 mass%, it becomes difficult to achieve a high polishing rate for barrier metals, while if it is over 20 mass% the further increase gives less improvement in the polishing rate for barrier metals, and is therefore uneconomical.

The organic acid used for the invention will now be explained.

The organic acid is added with the oxidizing agent to give an effect of increased polishing rate for barrier metals.

There are no particular restrictions on the organic acid, but carboxylic acids are preferred because of their low cost and ready availability in the industry, and of few problems in terms of safety.

As carboxylic acids suitable for use there may be mentioned malic acid, nicotinic acid, gluconic acid, citric acid, tartaric acid, succinic acid, acetic acid, oxalic acid, adipic acid, butyric acid, capric acid, caproic acid, caprylic acid, glutaric acid, glycolic acid, formic acid, fumaric acid, maleic acid, malonic acid, phthalic acid, propionic acid and pyruvic acid, which may be used alone or in combinations of more than one.

The concentration of the organic acid is preferably 0.01-20 mass%, more preferably 0.1-15 mass% and even more preferably 0.5-10 mass%. At less than 0.01 mass% it becomes difficult to achieve a high polishing rate for barrier metals, while it is preferably not over 20 mass% because the copper may dissolve during polishing. All or a portion of the organic acid may be in the form of a salt reacted with an alkali substance.

The oxidizing agent used for the invention will now be explained.

The oxidizing agent has an effect of increasing the polishing rate by accelerating the metal oxidation reaction during CMP. The oxidizing agent used is not particularly restricted so long as it is water-soluble, and as examples there may be mentioned hydrogen peroxide, permanganic acid compounds such as potassium permanganate, chromic acid compounds such as sodium chromate, nitric acid compounds such as nitric acid, peroxo acid compounds such as peroxodisulfuric acid, oxo acid compounds such as perchloric acid, transition metal salts such as potassium ferricyanide, organic-based oxidizing agents such as peracetic acid and nitrobenzene, etc. Among these, hydrogen peroxide is particularly preferred because it contains no metal components, its by-products and decomposition products from a reaction are harmless, and it has a history of practical use as a cleaning reagent in the semiconductor industry.

The concentration of the oxidizing agent is preferably 0.01-20 mass%, more preferably 0.1-15 mass% and even more preferably 0.5-10 mass%. At less than 0.01 mass% it becomes difficult to achieve a high polishing rate for barrier metals, while it is preferably not over 20 mass% because the copper may dissolve during polishing.

When hydrogen peroxide is used as the oxidizing agent in the polishing composition of the invention, it is preferred to prevent variation in the composition due to decomposition of hydrogen peroxide during storage by separately preparing aqueous hydrogen peroxide at a prescribed concentration and composition as the desired polishing composition by addition of hydrogen peroxide, and combining these just before use for the chemical mechanical polishing.

The polishing composition of the invention may also contain various additives that are known in the relevant field, such as viscosity adjustors, pH regulators, buffering agents, chelating agents, surfactants, organic acids and their salts, etc.

The polishing composition of the invention is used to form the metal wiring layer for an LSI device, and more specifically, it serves to form a copper-based metal wiring layer having copper deposited on an insulating film with a barrier metal composed of Ta or TaN therebetween.

With reference to the drawings, a silicon dioxide film 2 is formed on a silicon wafer 1, for example, by thermal oxidation, and a depression 3 is formed in the silicon dioxide film 2, as shown in Figure, corresponding to the wiring pattern. The depression may be formed by lithography or the like.

Next, as shown in Fig. 2, a barrier metal layer 4 composed of Ta or TaN is formed over the entire surface of the silicon dioxide film 2 including the depression 3. The barrier metal serves to prevent diffusion (reaction) of copper into the silicon dioxide, and the thickness of the barrier metal layer may usually be about 5-200 nm. The barrier metal layer 4 may be formed by sputtering or CVD.

After formation of the barrier metal layer 4, copper is deposited onto the entire surface to completely fill the depression 3 with copper. At this time, the copper 5 deposited not only in the depression 3 but also over the entire surface of the barrier metal layer 4 on the silicon dioxide film. The deposition of the copper layer 5 may be accomplished by any method such as sputtering, CVD or plating, so long as the depression 3 is completely filled.

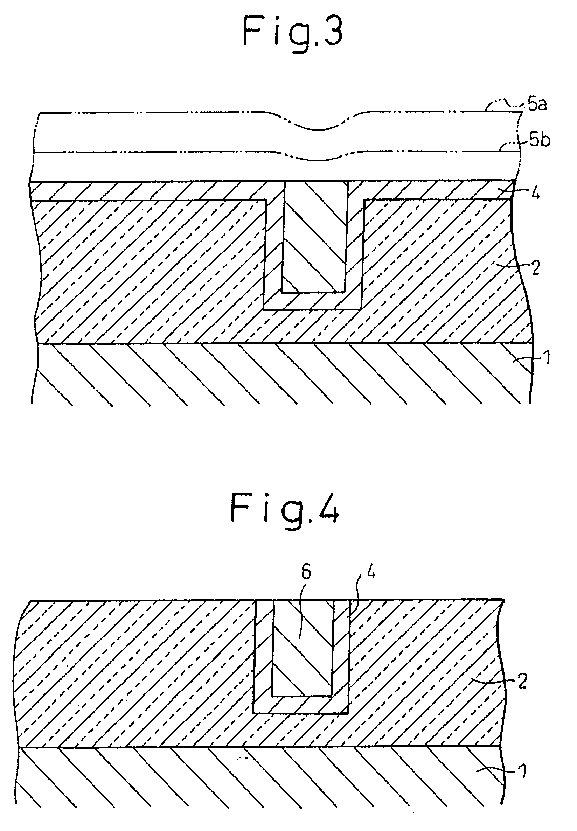

As shown in Figs. 3 and 4, the copper layer 5 is polished using a polishing composition according to the invention. The copper layer is polished in the order shown by 5a and 5b in Fig. 3, and is then polished to the same height as the surface of the barrier metal layer 4. The polishing involves polishing of the silicon wafer surface using a polishing pad and the polishing composition, and therefore the wafer surface is polished basically to flatness as shown by 5a and 5b; however, the polishing has both the effect of mechanical polishing and chemical etching, and therefore although flat polishing is achieved in the case of copper alone, the polishing is not necessarily at the same polishing rate when polishing a copper layer 5 and barrier metal layer 4 simultaneously. The polishing composition of the invention is modified to allow an equal polishing rate for the hard barrier metal composed of Ta or TaN and the relatively softer or acid-corroding copper. When the copper used as the wiring layer undergoes corrosion with acid it can result in deterioration of the device, and it is therefore preferable to prevent this. When the polishing composition of the invention is used for simultaneous polishing of copper and the barrier metal, as shown in Fig. 4, polishing of the barrier metal layer 4 on the silicon dioxide film 2 allows the surface of the copper 6 in the depression 3 to substantially match the surface of the silicon dioxide film 2 to achieve flatness, so that erosion by the polishing composition can also be prevented.

Examples

Examples will now be provided for a more detailed explanation of the invention, with the understanding that the invention is in no way limited by these examples.

Example 1

After suspending 3 kg of silicon oxide produced by a vapor phase method (specific surface area: 230 $m^2/g$, $d_{50} = 0.12\ \mu m$, $d_{max} = 0.41\ \mu m$, residual chlorine concentration: 0.1 mass%) in 7 kg of purified water, an ordinary stirrer was used for 30 minutes of stirring to obtain a slurry. A silane coupling agent (A-1120, 300 g of 3-(aminoethylaminopropyl)trimethoxysilane, product of Nihon Unicar Co., Ltd.) was added to the slurry, and after another 20 hours of stirring, the solid portion was filtered off and heat treatment was carried out at 120°C for 2 hours to obtain silicon oxide abrasive particles surface treated with the silane coupling agent. Here, the silane coupling agent was used at 10 wt% with respect to the silicon oxide abrasive particles.

A purified water polishing solution was prepared with 4 mass% of the silicon oxide abrasive particles obtained in this manner, 1 mass% of malic acid, a pH adjusted to 8.5 with KOH and also containing 2 mass% of hydrogen peroxide.

The polishing evaluation of the polishing composition for Cu and Ta was as follows.

[Polishing conditions]

Polishing materials:

i) Cu film-coated wafer
Fabricated by forming a thermal oxidation film to 100 nm, a TaN film to 50 nm and a Cu film to 1100 nm on a 6"$\phi$ silicon wafer.
ii) Ta film-coated wafer
Fabricated by forming a thermal oxidation film to 100 nm and a Ta film to 500 nm on a 6"$\phi$ silicon wafer.

Polishing pad: IC1000/SUBA400 by Rodel-Nitta Co.
Polishing machine: One-side polishing machine for polishing LSI device (Model SH-24 by SpeedFam, Inc.)
Table rotating speed: 70 rpm
Working pressure: 300 gf/cm$^2$
Slurry supply rate: 100 ml/min
Polishing time: 60 sec

[Evaluation and evaluation method]

Polishing rate: Sheet resistance measuring apparatus (Cu film, Ta film: Calculated by determining the film thickness from the sheet resistance value, and dividing the amount removed by the polishing time.)
Cu dissolution rate: Calculated by immersing a Cu film-coated wafer strip for 1 hour in a slurry provided for the polishing test (temperature: 20°C), measuring the sample weight before and after immersion, and using the following formula incorporating the surface area, density and immersion time.

$$\text{Dissolution rate} = (\text{weight before immersion} - \text{weight}$$

$$\text{after immersion})/(\text{density x sample surface area x}$$

$$\text{immersion time})$$

Scratches: Optical microscope observation (Observation of wafer surface at 100x magnification) The results of the above polishing test are shown in Table 1.

Example 2

A slurry was prepared under the same conditions as in Example 1 except that the silicon oxide abrasive particles were used at 2 mass% instead of 4 mass%, and evaluation of the polishing performance in the same manner as Example 1 gave the results shown in Table 1.

Example 3

A slurry was prepared under the same conditions as in Example 2 except that the surface treatment agent was used at 15 mass% with respect to the abrasive particles, and evaluation of the polishing performance in the same manner as Example 1 gave the results shown in Table 1.

Example 4

A slurry was prepared under the same conditions as in Example 2 except that the pH was adjusted to 7.0 instead of 8.5, and evaluation of the polishing performance in the same manner as Example 1 gave the results shown in Table 1.

Example 5

A slurry was prepared under the same conditions as in Example 2 except that the pH was adjusted to 6.0 instead of 8.5, and evaluation of the polishing performance in the same manner as Example 1 gave the results shown in Table 1.

Example 6

A slurry was prepared under the same conditions as in Example 2 except that tartaric acid was used instead of malic acid, and evaluation of the polishing performance in the same manner as Example 1 gave the results shown in Table 1.

Example 7

A slurry was prepared under the same conditions as in Example 2 except that adipic acid was used instead of malic acid, and evaluation of the polishing performance in the same manner as Example 1 gave the results shown in Table 1.

Example 8

A slurry was prepared under the same conditions as in Example 2 except that 10 mass% of malic acid was used instead of 1 mass% of malic acid, and evaluation of the polishing performance in the same manner as Example 1 gave the results shown in Table 1.

Example 9

A slurry was prepared under the same conditions as in Example 2 except that the pH was adjusted using 2,2,6,6-tetramethyl-4-hydroxypiperidine instead of KOH, and evaluation of the polishing performance in the same manner as Example 1 gave the results shown in Table 1.

Example 10

A slurry was prepared under the same conditions as in Example 1 except that silicon oxide with a specific surface area of 160 $m^2$/g was used instead of silicon oxide with a specific surface area of 230 $m^2$/g, and evaluation of the polishing performance in the same manner as Example 1 gave the results shown in Table 1.

Example 11

A slurry was prepared under the same conditions as in Example 2 except that titanium oxide (specific surface area: 200 $m^2$/g, $d_{50}$ = 0.12 $\mu$m, $d_{max}$ = 0.43 $\mu$m, residual chlorine concentration: 0.2 mass%) was used instead of silicon oxide, and evaluation of the polishing performance in the same manner as Example 1 gave the results shown in Table 1.

Example 12

A slurry was prepared under the same conditions as in Example 2 except that aluminum oxide (specific surface area: 200 $m^2$/g, $d_{50}$ = 0.13 $\mu$m, $d_{max}$ = 0.45 $\mu$m, residual chlorine concentration: 0.1 mass%) was used instead of silicon oxide, and evaluation of the polishing performance in the same manner as Example 1 gave the results shown in Table 1.

Example 13

A slurry was prepared under the same conditions as in Example 2 except that oxalic acid was used instead of malic acid, and evaluation of the polishing performance in the same manner as Example 1 gave the results shown in Table 1.

Example 14

A slurry was prepared in the same manner as Example 1 but without surface treatment of the abrasive particles, and evaluation of the polishing performance in the same manner as Example 1 gave the results shown in Table 1.

Example 15

A slurry was prepared in the same manner as Example 2 except that the pH was adjusted to 9.5 instead of 8.5, and evaluation of the polishing performance in the same manner as Example 1 gave the results shown in Table 1.

Comparative Example 1

A slurry was prepared in the same manner as Example 2 except that the pH was adjusted to 5.0 instead of 8.5, and evaluation of the polishing performance in the same manner as Example 1 gave the results shown in Table 1. The Cu dissolution rate was clearly increased.

Comparative Example 2

A slurry was prepared in the same manner as Example 2 except that the pH was adjusted with ammonia water instead of KOH, and evaluation of the polishing performance in the same manner as Example 1 gave the results shown in Table 1. The Cu dissolution rate was clearly increased.

Comparative Example 3

A slurry was prepared in the same manner as Example 2 except that silicon oxide with a residual chlorine concentration of 0.5 mass% and tartaric acid were used instead of silicon oxide with a residual chlorine concentration of 0.1 mass% and malic acid, and evaluation of the polishing performance in the same manner as Example 1 gave the results shown in Table 1.

Comparative Example 4

A slurry was prepared in the same manner as Example 13 but without using an organic acid, and evaluation of the polishing performance in the same manner as Example 1 gave the results shown in Table 1.

EP 1 193 745 A1

Table 1  Polishing evaluation results for examples and comparative examples

| Example No. Comp.Ex.No. | Abrasive particles | | | | Organic acid | | pH | Polishing speed (nm/min) | | Selection ratio Ta/Cu | Cu dissolution rate (nm/min) | Scratches |
|---|---|---|---|---|---|---|---|---|---|---|---|---|
| | Abrasive particle type (wt%) | Abrasive particle content (wt%) | Area to weight ratio ($m^2/g$) | Surface treat-ment (wt%)[*1] | Type | Wt% | | Ta | Cu | | | |
| Example 1 | silicon oxide | 4 | 230 | 10 | malic acid | 1.0 | 8.5 | 87 | 48 | 1.8 | 0 | none |
| Example 2 | silicon oxide | 2 | 230 | 10 | malic acid | 1.0 | 8.5 | 47 | 35 | 1.3 | 0 | none |
| Example 3 | silicon oxide | 2 | 230 | 15 | malic acid | 1.0 | 8.5 | 57 | 42 | 1.4 | 0 | none |
| Example 4 | silicon oxide | 2 | 230 | 10 | malic acid | 1.0 | 7.0 | 52 | 44 | 1.2 | 0.2 | none |
| Example 5 | silicon oxide | 2 | 230 | 10 | malic acid | 1.0 | 6.0 | 53 | 48 | 1.1 | 0.4 | none |
| Example 6 | silicon oxide | 2 | 230 | 10 | tartaric acid | 1.0 | 8.5 | 63 | 34 | 1.9 | 0.8 | none |
| Example 7 | silicon oxide | 2 | 230 | 10 | adipic acid | 1.0 | 8.5 | 52 | 32 | 1.6 | 0 | none |
| Example 8 | silicon oxide | 2 | 230 | 10 | malic acid | 10.0 | 8.5 | 69 | 38 | 1.8 | 0.2 | none |
| Example 9 | silicon oxide | 2 | 230 | 10 | malic acid | 1.0 | 8.5[*2] | 45 | 32 | 1.4 | 0.2 | none |
| Example 10 | silicon oxide | 4 | 160 | 10 | malic acid | 1.0 | 8.5 | 96 | 39 | 2.5 | 0 | none |
| Example 11 | titanium oxide | 2 | 200 | 10 | malic acid | 1.0 | 8.5 | 51 | 45 | 1.1 | 0.5 | none |
| Example 12 | aluminum oxide | 2 | 200 | 10 | malic acid | 1.0 | 8.5 | 62 | 60 | 1.0 | 0.2 | none |
| Example 13 | silicon oxide | 2 | 230 | 10 | oxalic acid | 1.0 | 8.5 | 55 | 49 | 1.1 | 0.2 | none |
| Example 14 | silicon oxide | 4 | 230 | none | malic acid | 1.0 | 8.5 | 71 | 40 | 1.8 | 0 | none |
| Example 15 | silicon oxide | 2 | 230 | 10 | malic acid | 1.0 | 9.5 | 41 | 36 | 1.1 | 0 | none |
| Comp. Ex. 1 | silicon oxide | 2 | 230 | 10 | malic acid | 1.0 | 5.0 | 50 | 297 | 0.2 | 7.4 | none |
| Comp. Ex. 2 | silicon oxide | 2 | 230 | 10 | malic acid | 1.0 | 8.5[*3] | 47 | 132 | 0.4 | 3.1 | none |
| Comp. Ex. 3 | silicon oxide | 2[*4] | 230 | 10 | tartaric acid | 1.0 | 8.5 | 65 | 62 | 1.0 | 2.0 | none |
| Comp. Ex. 4 | silicon oxide | 2 | 230 | 10 | none | - | 8.5 | 13 | 21 | 0.6 | 1.6 | none |

(*1 Amount of surface treatment agent used with respect to abrasive particles.

*2 pH adjustment with hindered amine

*3 pH adjustment with ammonia water

*4 Residual chlorine concentration: 0.5 wt%.

Incidentally, although Ta polishing was evaluated in the examples given above, it is commonly known that the polishing rate for TaN is similar to that of Ta.

Industrial Applicability

The present invention provides a high polishing rate for barrier metals such as Ta and TaN and an excellent balance with the polishing rate for copper and therefore prevents dishing while also preventing erosion of copper, and it is, hence, particularly useful for damascene methods used for LSI devices.

**Claims**

1. A polishing composition for an LSI device, which is used to form a metal wiring layer, comprising water, abrasive particles, an organic acid and an oxidizing agent and having the pH adjusted to 5.5-10.0 with an alkali substance.

2. A polishing composition for an LSI device, which is used to form a metal wiring layer, comprising water, abrasive particles, an organic acid and an oxidizing agent and having the pH adjusted to 5.5-9.0 with an alkali substance.

3. A polishing composition for an LSI device according to claim 1 or 2, which is used for polishing a copper-based metal wiring layer having copper deposited on an insulating film by way of a barrier metal composed of Ta or TaN.

4. A polishing composition for an LSI device, according to claim 1, 2 or 3, wherein the ratio of the polishing rate for the barrier metal composed of Ta or TaN and the polishing rate for copper is 1.0 or greater.

5. A polishing composition for an LSI device, according to any one of claims 1 to 4, wherein the copper dissolution rate is no greater than 5 nm/min.

6. A polishing composition for an LSI device, according to any one of claims 1 to 5, wherein the copper dissolution rate is no greater than 1 nm/min.

7. A polishing composition for an LSI device, according to any one of claims 1 to 6, wherein said alkali substance is KOH.

8. A polishing composition for an LSI device, according to any one of claims 1 to 6, wherein said alkali substance is at least one type of hindered amine selected from among 2,2,6,6-tetramethyl-4-hydroxypiperidine, 2,2,6,6-tetramethylpiperidine, 2,2,6,6-tetramethyl-4-piperidone, 2,2,4,4,6-pentamethyl-2,3,4,5-tetrahydropyrimidine, 1,9-diaza-2,2,8,8,10,10-hexamethyl-spiro[5.5]undecan-4-one, 6-aza-7,7-dimethylspiro[4.5]decan-9-one and 1-aza-2,2-dimethylspiro[5.5]undecan-4-one.

9. A polishing composition for an LSI device, according to any one of claims 1 to 8, wherein said abrasive particles are composed mainly of at least one type of compound selected from among silicon oxide, aluminum oxide, cerium oxide, titanium oxide, zirconium oxide, complex metal oxides and metal hydroxides.

10. A polishing composition for an LSI device, according to any one of claims 1 to 9, wherein said abrasive particles are of silicon oxide produced by a gas phase method.

11. A polishing composition for an LSI device, according to any one of claims 1 to 10, wherein said abrasive particles have been surface treated with a coupling agent.

12. A polishing composition for an LSI device, according to any one of claims 1 to 11, wherein said coupling agent has one or more amino groups.

13. A polishing composition for an LSI device, according to any one of claims 1 to 12, wherein said organic acid is at least one organic acid selected from among malic acid, nicotinic acid, gluconic acid, citric acid, tartaric acid, succinic acid, acetic acid, oxalic acid, adipic acid, butyric acid, capric acid, caproic acid, caprylic acid, glutaric acid, glycolic acid, formic acid, fumaric acid, maleic acid, malonic acid, phthalic acid, propionic acid and pyruvic acid.

14. A polishing composition for an LSI device, according to any one of claims 1 to 13, wherein said oxidizing agent is hydrogen peroxide.

15. A manufacturing process for an LSI device, whereby a structure is provided comprising a copper-based metal wiring layer having copper deposited on an insulating film by way of a barrier metal composed of Ta or TaN and said structure is polished with a polishing composition, wherein said polishing composition comprises water, abrasive particles, an organic acid and an oxidizing agent and has its pH adjusted to 5.5-9.0 with an alkali substance.

16. A manufacturing process for an LSI device according to claim 15, wherein a barrier metal layer composed of Ta or TaN is formed on the entire surface of an insulating film including a depression formed therein, copper is deposited on the barrier metal layer so that the depressions is completely buried with copper, and the copper on the barrier metal layer and the barrier metal are then polished using said polishing composition while selectively leaving the copper embedded in the depression of said insulating film to form an embedded copper wiring layer.

# Fig.1

# Fig.2

# Fig.3

# Fig.4

<table>
<tr><td colspan="2">**INTERNATIONAL SEARCH REPORT**</td><td colspan="2">International application No.<br>PCT/JP01/00774</td></tr>
</table>

**A. CLASSIFICATION OF SUBJECT MATTER**
Int.Cl⁷  H01L21/304, C09K3/14

According to International Patent Classification (IPC) or to both national classification and IPC

**B. FIELDS SEARCHED**

Minimum documentation searched (classification system followed by classification symbols)
Int.Cl⁷  H01L21/304, C09K3/14, B24B37/00

Documentation searched other than minimum documentation to the extent that such documents are included in the fields searched
Jitsuyo Shinan Koho        1920-1996    Toroku Jitsuyo Shinan Koho  1994-2001
Kokai Jitsuyo Shinan Koho  1971-1996    Jitsuyo Shinan Toroku Koho  1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | US, 5575885, A (Kabushiki Kaisha Toshiba),<br>19 November, 1996 (19.11.96),<br>Full text<br>& JP, 7-233485, A (Toshiba Corporation), | 1,2,7,9,10 |
| Y | 05 September, 1995 (05.09.95),<br>& EP, 659858, A     & KR, 165145, A | 3-6,8,11-16 |
| Y | EP, 811665, A (Cabot Corporation),<br>10 December, 1997 (10.12.97),<br>Full text<br>& JP, 10-44047, A (Cabot Corporation),<br>07 February, 1998 (17.02.98),<br>& US, 5858813, A     & WO, 9743087, A<br>& AU, 9728048, A     & TW, 332895, A<br>& KR, 97074892, A | 1-16 |
| PX | JP, 2000-306873, A (Tokuyama Corporation),<br>02 November, 2000 (02.11.00),<br>Full text   (Family: none) | 1-4,9,10,14-16 |
| PY | | 5-8,11-13 |

☒ Further documents are listed in the continuation of Box C.    ☐ See patent family annex.

| | |
|---|---|
| \* Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>24 April, 2001 (24.04.01) | Date of mailing of the international search report<br>15 May, 2001 (15.05.01) |
| Name and mailing address of the ISA/<br>Japanese Patent Office | Authorized officer |
| Facsimile No. | Telephone No. |

Form PCT/ISA/210 (second sheet) (July 1992)

**EP 1 193 745 A1**

## INTERNATIONAL SEARCH REPORT

| International application No. |
|---|
| PCT/JP01/00774 |

C (Continuation).   DOCUMENTS CONSIDERED TO BE RELEVANT

| Category* | Citation of document, with indication, where appropriate, of the relevant passages | Relevant to claim No. |
|---|---|---|
| EX | JP, 2001-31950, A (Tokuyama Corporation),<br>06 February, 2001 (06.02.01),<br>Full text   (Family: none) | 1-4,7,9,10,<br>13-16 |
| EY |  | 5,6,8,11,12 |
| EA | JP, 2001-35820, A (Hitachi Chemical Co., Ltd.),<br>09 February, 2001 (09.02.01)   (Family: none) | 1-16 |
| EA | JP, 2001-68438, A (Speedfam Co., Ltd.),<br>16 March, 2001 (16.03.01)   (Family: none) | 1-16 |

Form PCT/ISA/210 (continuation of second sheet) (July 1992)

18